# EUROPÄISCHE PATENTSCHRIFT

(11) **EP 3 204 782 B1**
(45) Veröffentlichungstag und Bekanntmachung des Hinweises auf die Patenterteilung: **12.12.2018**
(21) Anmeldenummer: 15783974.7
(22) Anmeldetag: 07.10.2015
(51) Int. Cl.: G01R 31/12, H02M 7/06

(54) **VERFAHREN ZUM ERMITTELN VON KENNGROESSEN EINES TEILENTLADUNGSVORGANGS**
METHOD FOR DETERMINING CHARACTERISTICS OF A PARTIAL DISCHARGE EVENT
PROCÉDÉ DE DÉTERMINATION DE PARAMÈTRES D'UN PROCÉDÉ DE DÉCHARGE PARTIELLE

(30) Priorität: 07.10.2014 DE 102014114563
(43) Veröffentlichungstag der Anmeldung: 16.08.2017
(73) Patentinhaber: Betz, Thomas, 63505 Langenselbold (DE)
(72) Erfinder: RADLER, Frank, 64293 Darmstadt (DE); DEZENZO, Tobias, 63065 Offenbach am Main (DE); SUNARYADI, Dody, 46196 Tasikmalaya (ID); BETZ, Thomas, 63505 Langenselbold (DE)
(74) Vertreter: Katscher Habermann Patentanwälte
(86) Internationale Anmeldenummer: PCT/EP2015/073138
(87) Internationale Veröffentlichungsnummer: WO 2016/055515

(56) Entgegenhaltungen:
- CN-A- 102 508 031
- DE-A1- 2 356 216
- DE-A1- 2 856 354
- JP-A- 2002 323 533
- JP-A- 2012 088 080

## Beschreibung

Die Erfindung betrifft ein Verfahren zum Ermitteln von Kenngrößen eines Teilentladungsvorgangs in einer elektrischen Hochspannungskomponente, in welcher eine Teilentladung detektiert und gemessen wird, wobei an der Hochspannungskomponente eine Gesamtspannung als Überlagerung von einer Betriebsgleichspannung und zusätzlich von einer sich mit der Zeit verändernden Messspannung angelegt wird, und dass mehrfach eine durch eine Teilentladung bewirkte Ladungsdifferenz relativ zu der Gesamtspannung und zeitgleich ein Phasenbezug dieser Teilentladung zu der sich mit der Zeit verändernden Messspannung erfasst wird, um anschließend eine Fehlererkennung anhand der charakteristischen Eigenschaften des Phasenbezugs der mehrfach gemessenen Teilentladungen durchzuführen.

Elektrische Hochspannungskomponenten, die Bestandteil einer Hochspannungsanlage sind, müssen während des Betriebs in der Hochspannungsanlage eine ausreichend große und zuverlässige Isolierung aufweisen, um elektrische Durchschläge und eine dadurch verursachte Beschädigung der elektrischen Hochspannungskomponenten und der Hochspannungsanlage zu vermeiden.

Oftmals treten aufgrund von stark inhomogenen Feldverläufen räumlich beschränkte Überschreitungen einer materialabhängigen Durchschlagsfeldstärke auf, sodass es zu Teilentladungen kommt, bei denen eine Isolierung zwischen der elektrischen Hochspannungskomponente und einer üblicherweise geerdeten Potentialfläche nur teilweise überbrückt wird, sodass lediglich eine Teilentladung der elektrischen Hochspannungskomponente stattfindet und kein vollständiger elektrischer Durchschlag erfolgt.

Eine derartige Teilentladung kann verschiedene Ursachen haben. Eine äußere Teilentladung entsteht zwischen einer Oberfläche der Hochspannungskomponente in einen umgebenden Luftraum, wobei hörbare und sichtbare Korona-Entladungen vorzugsweise an scharfkantigen Bereichen der Hochspannungskomponente entstehen. Innerhalb von Isoliermedien können innere Teilentladungen entstehen, bei denen begünstigt durch Inhomogenitäten des Isoliermediums Entladungen, jedoch keine vollständigen Durchschläge in dem Isoliermedium auftreten.

Sowohl äußere Teilentladungen wie beispielsweise Korona-Entladungen als auch innere Teilentladungen innerhalb eines Isoliermediums führen auf Dauer zu einer Beeinträchtigung der elektrischen Hochspannungskomponente und gegebenenfalls zu einer Beschädigung und zu einem Ausfall der elektrischen Hochspannungskomponente.

Um eine Beschädigung der elektrischen Hochspannungskomponenten und eine dadurch begünstigte Anfälligkeit der Hochspannungskomponente gegenüber elektrischen Durchschlägen, welche die elektrischen Hochspannungskomponente stark beeinträchtigen oder vollständig zerstören können, frühzeitig zu erkennen und gegebenenfalls zu vermeiden ist es aus der Praxis bekannt, dass Teilentladungen in der elektrischen Hochspannungskomponente detektiert und messtechnisch erfasst werden, um das Risiko einer baldigen Funktionsbeeinträchtigung oder Zerstörung der betreffenden elektrischen Hochspannungskomponente abzuschätzen und zu reduzieren.

Beispielsweise in DE 28 56 354 oder in DE 23 56 216 werden Verfahren beschrieben, mit deren Hilfe die Teilentladungen erfasst und ausgewertet werden können, die in einer elektrischen Hochspannungskomponente durch eine vorgegebene Prüfspannung verursacht werden. Dabei wird in DE 28 56 354 bereits angedeutet, dass die Erzeugung und eine für die nachfolgenden Messungen geeignete Einkopplung einer Prüfspannung erhebliche Schwierigkeiten verursachen kann. Die Messung und Auswertung der einzelnen Teilentladungen ist ebenfalls mit Problemen verbunden, wie es beispielsweise in CN 102508031 A beschrieben ist.

Bei einem aus der Praxis bekannten Auswerteverfahren können die zu überprüfenden Hochspannungskomponenten mit einer Wechselspannung beaufschlagt werden und die dabei detektierten, bzw. erzeugten Teilentladungen erfasst werden. Nachdem ein Bezug der gemessenen Teilentladung zu einer Phasenlage der für die Messung verwendeten Wechselspannung hergestellt wurde, können anhand der oftmals charakteristischen Verteilung einzelner Teilentladungen relativ zu der Phasenlage der für die Messung aufgeprägten Wechselspannung Rückschlüsse auf die Art der Teilentladung und damit auf die möglichen Auswirkungen eines Fehlers gezogen werden, der in der Hochspannungskomponente vorhanden ist und gegebenenfalls demnächst zu einer Überbeanspruchung und einem Versagen der elektrischen Hochspannungskomponente während des Betriebs führen könnte.

Untersuchungen haben ergeben, dass unterschiedliche Fehlerquellen, die für das Auftreten von Teilentladungen im Betrieb verantwortlich sind, jeweils charakteristische und unterscheidbare Abhängigkeiten von der Wechselspannung aufweisen, mit der die Teilentladungen im Betrieb oder bei einer erhöhten Prüfspannung nachgewiesen werden. Anhand der Phasenbeziehung zu der anregenden Wechselspannung, die für die einzelnen gemessenen Teilentladungen hergestellt werden kann, lässt sich nach einer ausreichend großen Anzahl von einzelnen Messungen von Teilentladungen eine Korrelation zwischen den Teilentladungen und der die Teilentladungen erzeugenden Wechselspannung herstellen und auf die Ursache der einzelnen Teilentladungen schließen.

In der Praxis sind deshalb verschiedene Messverfahren entwickelt worden, mit deren Hilfe ausgehend von einer Anzahl von Teilentladungen, die mit einer an der Hochspannungskomponente angelegten Wechselspannung erzwungen und mit einer Messeinrichtung erfasst wurden, die Art der Teilentladung ermitteln und dadurch Rückschlüsse auf die Fehlerursache und auf ein Ausfallrisiko der Hochspannungskomponente während eines weiteren Betriebs schließen.

Die aus der Praxis bekannten Messverfahren basieren auf einer zeitlichen Zuordnung einzelner Teilentladungen zu einer angelegten Wechselspannung. Wird die elektrische Hochspannungskomponente dagegen mit einer Gleichspannung betrieben, können dabei auftretende Teilentladungen nicht in Bezug zu einer Phasenlage einer Anregung gesetzt werden, sodass die aus der Praxis bekannten Auswerteverfahren nicht angewandt werden können. Wird eine Teilentladung durch eine Gleichspannung angeregt, können deshalb keine Rückschlüsse auf die Fehlerart und letztendlich auf das Ausfallrisiko der betreffenden Hochspannungskomponente gezogen werden können.

Würde die zu überprüfende Hochspannungskomponente von der Gleichspannungsquelle getrennt und mit einer Wechselspannung beaufschlagt werden, um die Messung und Auswertung der Teilentladungen mit dem aus der Praxis bekannten Messverfahren durchführen zu können, würden die Auswirkungen der während eines Betriebs der Hochspannungskomponente anliegenden Gleichspannung während des Messvorgangs nicht auftreten und deshalb nicht berücksichtigt werden können. Die anstelle der Betriebsgleichspannung separat angelegte Wechselspannung ermöglicht zwar die Detektion von Teilentladungen, ermöglicht aber keinen zuverlässigen Rückschluss auf die während des Betriebs der Hochspannungskomponente mit Gleichspannung auftretenden Teilentladungen und die Fehlerursache, bzw. das Ausfallrisiko der Hochspannungskomponente bei einem Betrieb mit Gleichspannung.

Aus JP 2012 088080 oder JP 2002 323533 ist es jeweils bekannt, eine mit einer Gleichspannungsquelle verbundene Hochspannungskomponente zusätzlich mit einer externen Wechselspannungsquelle zu verbinden und die während des üblichen Betriebs erzeugte Gleichspannung mit einer zusätzlichen Wechselspannung zu überlagern, um die während eines Prüfvorgangs auftretenden Teilentladungen zu messen und auswerten zu können. Hierfür sind jedoch eine individuelle Anpassung der Wechselspannungsquelle und eine für die Durchführung des Prüfvorgangs geeignete Verbindung mit der Hochspannungskomponente erforderlich, was mit einem erheblichen Aufwand und üblicherweise auch mit einer zumindest kurzzeitigen Unterbrechung des normalen Betriebs verbunden ist.

Es wird als eine Aufgabe der vorliegenden Erfindung angesehen, ein Verfahren zum Ermitteln von Kenngrößen eines Teilentladungsvorgangs in einer elektrischen Hochspannungskomponente so auszugestalten, dass während des üblichen Betriebs mit einer Betriebsgleichspannung beaufschlagte Hochspannungskomponenten mit dem Verfahren gemessen und überprüft werden können.

Diese Aufgabe wird erfindungsgemäß nach dem Verfahrensanspruch 1 dadurch gelöst, dass die Messspannung ausgehend von einer Restwelligkeit der aus einer Wechselspannung erzeugten Betriebsgleichspannung erzeugt wird, indem entweder eine bereits vorhandene und eine ausreichend große Amplitude aufweisende Restwelligkeit ausgenutzt oder eine Restwelligkeit der Betriebsgleichspannung verstärkt wird, um eine Amplitude der verstärkten Restwelligkeit von mindestens 3 %, vorzugsweise von mehr als 10 % und besonders vorzugsweise von mehr als 20 % der Betriebsgleichspannung zu erhalten. Die für den Betrieb der elektrischen Hochspannungskomponente erforderliche Hochspannung wird in der Praxis nahezu ausnahmslos aus einer Wechselspannung erzeugt, die mit Hilfe einer Gleichrichtereinrichtung in eine möglichst gleichbleibende Betriebsgleichspannung umgewandelt wird. Dabei wird oftmals auch mit aufwändigen Gleichrichtereinrichtungen keine vollständig konstante Betriebsgleichspannung erreicht, sondern die Spannungsschwankungen der Wechselspannung weitgehend, aber nicht vollständig reduziert. Die Restwelligkeit ist eine Kenngröße der nach der Gleichrichtung der Wechselspannung verbleibenden periodischen Spannungsschwankungen, die bei effizienten Gleichrichtereinrichtungen auf weniger als 1 % bis 2 % einer Ausgangsamplitude der Wechselspannung reduziert werden kann.

Diese Restwelligkeit weist üblicherweise regelmäßige periodische Schwankungen auf, deren Phase und Frequenz von der für die Erzeugung der Betriebsgleichspannung verwendeten Wechselspannung vorgegeben werden. Es hat sich gezeigt, dass bereits mit einer geringfügigen Verstärkung dieser Restwelligkeit ein regelmäßiger periodischer Wechselspannungsanteil erzeugt werden kann, der der Betriebsgleichspannung überlagert wird. Die in geeigneter Weise verstärkte Restwelligkeit ermöglicht bei auftretenden Teilentladungen gleichzeitig die Ermittlung eines Phasenbezugs der erzeugten Teilentladungen mit der verstärkten Restwelligkeit, welche die Fehlerzuordnung der Teilentladungen erlaubt.

Die während eines regulären Betriebs der Hochspannungskomponente möglichst effiziente Gleichrichtung der Wechselspannung kann dadurch gezielt beeinflusst werden, um einen periodisch schwankenden Wechselspannungsanteil beizubehalten, der dem durch die unvollständige Gleichrichtung erzeugten Gleichspannungsanteil überlagert wird. Die Modifikation der Gleichrichtung kann beispielsweise durch eine gezielte Fehlansteuerung der für die Gleichrichtung verwendeten Halbleiterelemente bzw. gegebenenfalls durch eine Verstellung von den Zündwinkeln der Halbleiterelemente vorgenommen werden.

Gemäß einer vorteilhaften Ausgestaltung des Erfindungsgedankens ist vorgesehen, dass der Phasenbezug in einem gesonderten Messzweig relativ zu der Messspannung und getrennt von einem Messzweig für die Messung der Teilentladung erfasst wird. Die Teilentladung bzw. eine dadurch verursachte Ladungsdifferenz kann in einem Messzweig relativ zu der Betriebsgleichspannung oder zu der durch Überlagerung erzeugten Gesamtspannung erfasst werden. Eine Messung des Phasenbezugs relativ zu der Messspannung und eine Messung der Teilentladung relativ zu der Betriebsgleichspannung oder der Gesamtspannung wird im Sinne der vorliegenden Erfindung als eine Messung aufgefasst, die an Bereichen der Hochspannungskomponenten oder der mit diesen Hochspannungskomponenten in Verbindung stehenden Spannungsquelle durchgeführt werden, in denen überwiegend oder ausschließlich die Messspannung, bzw. die Betriebsgleichspannung oder die resultierende Gesamtspannung anliegt. Eine Messung in gesonderten Messzweigen kann eine räumlich beabstandete Messung des Phasenbezugs und der Teilentladung umfassen. Es wird jedoch nicht als eine Messung in gesonderten Messzweigen angesehen, wenn die Messungen mit in Reihe geschalteten Messeinrichtungen oder sogar mit derselben Messeinrichtung durchgeführt werden.

Die Messung einer Teilentladung kann beispielsweise mit Hilfe eines ersten Koppelkondensators erfolgen, der zwischen der mit der Betriebsgleichspannung oder mit der Gesamtspannung beaufschlagten Hochspannungskomponente und einem Erdleiter angeordnet ist. Die Messung des Phasenbezugs einer derart vorgenommenen Teilentladungsmessung kann an einer Wechselspannungsquelle vorgenommen werden, die mit Hilfe einer Gleichrichtereinrichtung die an der Hochspannungskomponente anliegende Betriebsgleichspannung erzeugt. Es muss lediglich sichergestellt werden, dass eine während einer Teilentladungsmessung ermittelte Phasenlage der sich mit der Zeit verändernden Messspannung zu der Wechselspannungsquelle eine zeitlich bekannte Abhängigkeit aufweist, die für die gemessene Teilentladung ausschlaggebend ist.

Durch die auch in räumlicher Hinsicht bestehende Auftrennung der Messung der Teilentladung einerseits und der Messung des Phasenbezugs dieser Teilentladung zu der verursachenden und zeitlich sich verändernden Messspannung andererseits lässt sich eine für einen vorgegebenen Fehlertyp charakteristische Abhängigkeit der Teilentladungen von der jeweiligen Phasenlage ermitteln und auswerten.

In vorteilhafter Weise ist vorgesehen, dass die Teilentladung mit Hilfe eines ersten Koppelkondensators ermittelt wird, dass der Phasenbezug mit Hilfe eines zweiten Koppelkondensators ermittelt wird, wobei die Kapazität Cₖ₂ des zweiten Koppelkondensators wesentlich größer als die Kapazität Cₖ₁ des ersten Koppelkondensators ist. Die an dem ersten Koppelkondensator und an dem zweiten Koppelkondensator auftretenden Ladungsdifferenzen und dadurch bewirkten Ausgleichsströme können kostengünstig und äußerst zuverlässig präzise mit Hilfe von Vierpolen bzw. Zweitorschaltungen ermittelt und ausgewertet werden.

Es ist ebenfalls denkbar und für bestimmte Anwendungsfälle vorteilhaft, dass die Ermittlung des Phasenbezugs mit Hilfe eines Lichtsignals einer von der Messspannung gespeisten Leuchtdiode getriggert wird. Es sind handelsübliche elektronische Messbausteine bekannt, mit deren Hilfe eine auftretende Ladungsdifferenz in einen zeitlichen Bezug zu einem extern erzeugten Lichtsignal bzw. ganz allgemein in einen Bezug zu einer getriggerten Zeitinformation gesetzt werden kann. Ein geeignetes Lichtsignal kann mit handelsüblichen und kostengünstigen Bauteilen erzeugt werden, wobei eine hohe Sensitivität des Lichtsignals bezüglich der sich mit der Zeit verändernden Messspannung besteht. Mit einem derartigen Messverfahrensschritt kann zuverlässig und mit hoher Genauigkeit eine zeitliche Veränderung der Messspannung nachgewiesen und für die Ermittlung des Phasenbezugs einer gleichzeitig erfolgenden Teilentladung herangezogen und verwendet werden.

Einer besonders vorteilhaften Ausgestaltung des Erfindungsgedankens zufolge ist vorgesehen, dass als Messspannung eine Wechselspannung verwendet wird, deren Scheitelwert weniger als 50 % der Betriebsgleichspannung, vorzugsweise weniger als 30 % und besonders vorzugsweise weniger als 15 % der Betriebsgleichspannung aufweist. Die Wechselspannung kann beispielsweise durch einen Transformator erzeugt werden, der an einer geeigneten Stelle in die Spannungsversorgung der Hochspannungskomponente eingebunden wird.

Es hat sich gezeigt, dass in vielen Fällen lediglich eine Wechselspannung mit einer kleinen Amplitude im Vergleich zu der Betriebsgleichspannung erforderlich ist, um die für eine Fehlererkennung erforderlichen Teilentladungen zu erzeugen und auszuwerten. Durch die Überlagerung der Betriebsgleichspannung mit einer Wechselspannung, die beispielsweise eine Frequenz von 50 Hz, aber auch eine geringere oder deutlich höhere Frequenz aufweisen kann, können innerhalb einer kurzen Messdauer eine große Anzahl von Teilentladungen erzwungen und ausgewertet werden. Die Messung des Phasenbezugs kann in einfacher Weise an der Wechselspannung vorgenommen werden oder ausgehend von den bekannten Vorgaben bei der Erzeugung der Wechselspannung abgeleitet und mit den gemessenen Teilentladungen korreliert werden.

Gemäß einer Ausgestaltung des Erfindungsgedankens ist vorgesehen, dass die Hochspannungskomponente wiederholt mit einer impulsförmigen Stoßspannung beaufschlagt wird.

Es ist insbesondere bei einer als Hochspannungskabel ausgestalteten Hochspannungskomponente ebenfalls denkbar, dass die Hochspannungskomponente mit einer Wanderwelle beaufschlagt wird.

Gemäß einer weiteren Ausgestaltung des Erfindungsgedankens ist vorgesehen, dass jeweils nur die positive oder die negative Betriebsgleichspannungskomponente mit einer gleichgerichteten Wechselspannung beaufschlagt wird.

Im Rahmen einer erfindungsgemäßen Auswertung der Messergebnisse des Teilentladungsmesssystems ist vorgesehen, dass eine Analyse der Messergebnisse mit Hilfe von statistischen Auswerteverfahren zu einer Erkennung von komplexen oder überlagerten Teilentladungen verwendet wird.

Vorzugsweise erfolgt über Schalteinrichtungen eine gezielte Messung von Teilentladungen der positiven oder der negativen Polarität über die Auskopplung mit Hilfe von niederspannungsseitigen Koppelkondensatoren.

Nachfolgend werden Ausführungsbeispiele des Erfindungsgedankens näher erläutert, die in der Zeichnung dargestellt sind. Es zeigt:
Fig. 1 eine schematische Darstellung einer Messeinrichtung für eine Hochspannungskomponente, wobei über einen ersten Koppelkondensator und einen ersten Vierpol ein Phasenbezug zu einer Wechselspannung ermittelt und über einen zweiten Koppelkondensator und einen zweiten Vierpol eine Teilentladung in einer Hochspannungskomponente ermittelt wird, an der eine Betriebsgleichspannung und eine sich mit der Zeit verändernde Messspannung anliegt,
Fig. 2 eine schematische Darstellung einer abweichend ausgestalteten Messeinrichtung, bei der über einen Transformator eine Wechselspannung als Messspannung eingekoppelt wird und die Ermittlung des Phasenbezugs relativ zu der Wechselspannung über einen ersten Koppelkondensator und einen ersten Vierpol ermittelt wird,
Fig. 3 eine schematische Darstellung einer abweichend ausgestalteten Messeinrichtung, bei der eine Leuchtdiode in Abhängigkeit von der zeitlichen Veränderung des Messspannungsanteils in einem gesonderten Messzweig aufleuchten und eine Ermittlung eines Phasenbezugs auslösen,
Fig. 4 eine schematische Darstellung einer Anzahl von gemessenen Teilentladungen in Abhängigkeit von der jeweils zugeordneten Phasenbeziehung, wobei die Teilentladungen ausschließlich durch eine Gleichspannung erzeugt sind,
Fig. 5 eine schematische Darstellung einer Anzahl von gemessenen Teilentladungen in Abhängigkeit von der jeweils zugeordneten Phasenbeziehung, wobei die Teilentladungen durch eine Messspannung mit einem Wechselspannungsanteil von 5 kV ausgelöst sind, die einer Gleichspannung von 50 kV überlagert ist, und wobei die Teilentladungen durch Lunker in einem Isolierungsmaterial der Hochspannungskomponente verursacht werden,
Fig. 6 eine schematische Darstellung einer Anzahl von gemessenen Teilentladungen in Abhängigkeit von der jeweils zugeordneten Phasenbeziehung, wobei die Teilentladungen durch eine verstärkte Restwelligkeit der aus einer Wechselspannung erzeugten Gleichspannung ausgelöst sind, und wobei die Teilentladungen durch eine äußere Korona-Entladung verursacht werden,
Fig. 7 eine schematische Darstellung einer Überlagerung einer Wechselspannung mit Hilfe eines in Reihe geschalteten und über Koppelkondensatoren eingebundenen Transformators mit einem geerdeten Mittenabgriff,
Fig. 8 eine schematische Darstellung einer abweichend ausgestalteten Überlagerung einer Wechselspannung, die durch zwei separate Transformatoren über hochspannungsseitig angeordnete Koppelkondensatoren der Gleichspannung überlagert wird, und über niederspannungsseitig angeordnete Koppelkondensatoren eine Teilentladungsmessung erfolgt,
Fig. 9 eine schematische Darstellung einer wiederum abweichend ausgestalteten Überlagerung einer Wechselspannung, die über einen Transformator mit geerdetem Mittenabgriff eingekoppelt wird, und wobei eine Teilentladungsmessung über hochspannungsseitige und niederspannungsseitige Koppelkondensatoren erfolgt,
Fig. 10 eine schematische Darstellung einer Messeinrichtung für eine Hochspannungsanlage mit einer Betriebsgleichspannungsquelle, einer alternativ zuschaltbaren Prüfspannungsquelle, einer zu prüfenden Hochspannungskomponente und einer wahlweise zuschaltbaren oder trennbaren Verbraucherlast,
Fig. 11 eine schematische Darstellung einer abweichend ausgestalteten Messeinrichtung, bei der ausgehend von einer Wechselspannung eine modifizierte Gleichrichtung erfolgt, so dass einem Gleichspannungsanteil ein Wechselspannungsanteil überlagert wird,

Fig. 12 eine schematische Darstellung einer wiederum abweichend ausgestalteten Messeinrichtung, wobei eine Restwelligkeit einer Gleichspannungsquelle verstärkt und der Gleichspannung überlagert wird,
Fig. 13 eine schematische Darstellung einer wiederum abweichend ausgestalteten Messeinrichtung, wobei ein Spannungsimpuls als Messspannung eingekoppelt wird,
Fig. 14 und 15 eine schematische Darstellung von polaritätsabhängigen Messungen von Teilentladungen in oder an der Hochspannungskomponente.

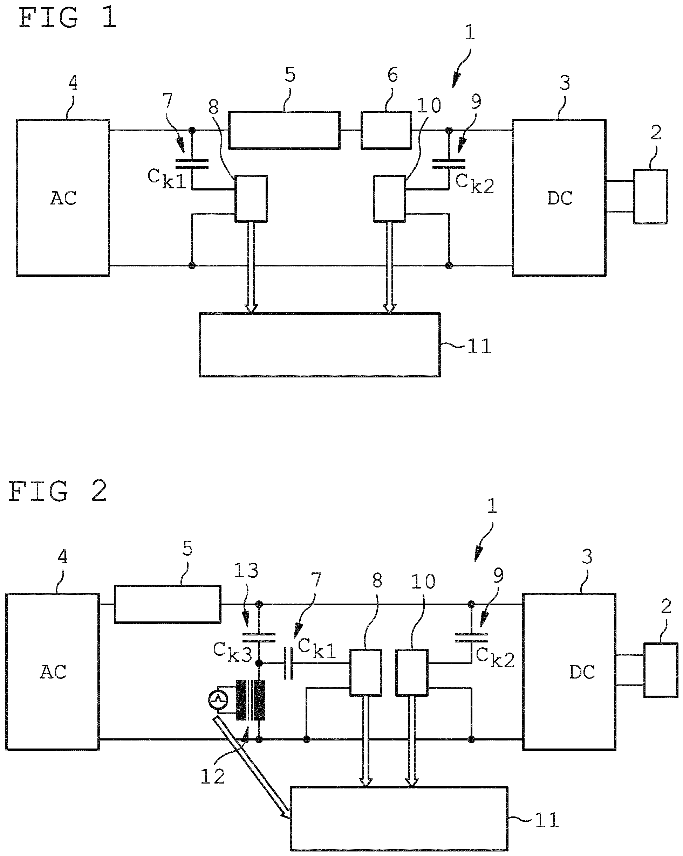

Fig. 1 zeigt eine schematische Darstellung einer Messeinrichtung 1 für eine Hochspannungskomponente 2, die exemplarisch als Bestandteil einer nicht näher gezeigten Hochspannungsanlage gezeigt ist. Die Hochspannungskomponente 2 wird über eine Gleichspannungseinrichtung 3 während eines Betriebs der Hochspannungsanlage mit einer Betriebsgleichspannung versorgt und betrieben. Die Gleichspannungseinrichtung 3 wird aus einer Wechselspannungseinrichtung 4 gespeist, deren Wechselspannung mit einer Gleichrichtereinrichtung 5 gleichgerichtet und in eine Gleichspannung umgewandelt wird. Nach der Gleichrichtereinrichtung 5 ist eine Verstärkereinrichtung 6 mit einer integrierten elektronischen Ansteuerung angeordnet, mit der die Restwelligkeit der Gleichrichtereinrichtung 5 verstärkt und als Wechselspannungsanteil dem mit der Gleichrichtereinrichtung 5 erzeugten Gleichspannungsanteil überlagert wird.

Über einen ersten Koppelkondensator 7 mit einer Kapazität Cₖ₁ und einen ersten Vierpol 8 wird ein Phasenbezug zu der Wechselspannung ermittelt, welche eine zeitliche Korrelation zu der verstärkten Restwelligkeit aufweist, die als zeitlich veränderliche Messspannung der Betriebsgleichspannung überlagert wird. Über einen zweiten Koppelkondensator 9 mit einer Kapazität Cₖ₂ und einen zweiten Vierpol 10 wird eine Teilentladung in der Hochspannungskomponente 2 ermittelt. Die Messsignale des ersten Vierpols 8 und des zweiten Vierpols 10 werden einem Teilentladungsmesssystem 11 zugeführt. Die Kapazität Cₖ₂ ist wesentlich größer als die Kapazität Cₖ₁.

Nach der Messung einer ausreichend großen Anzahl von Teilentladungen sowie der zugeordneten Phasenbezüge kann die Ermittlung von Kenngrößen des Teilentladungsvorgangs durchgeführt werden, was nachfolgend noch näher beschrieben wird.

In Fig. 2 ist exemplarisch eine schematische Darstellung einer abweichend ausgestalteten Messeinrichtung 1 gezeigt. An Stelle der Verstärkereinrichtung 6, mit welcher eine Restwelligkeit verstärkt und der Gleichspannung überlagert wird, wird eine Wechselspannung oder ein Spannungsimpuls durch einen geeigneten Transformator 12 bzw. Übertrager erzeugt und über einen hochspannungsseitig angeordneten dritten Koppelkondensator 13 der Gleichspannung überlagert. Der erste Vierpol 8 ist über den ersten Koppelkondensator 7 an die von dem Transformator 12 erzeugte Wechselspannung angekoppelt und erlaubt eine Ermittlung des Phasenbezugs über die Wechselspannung, die als sich mit der Zeit verändernde Messspannung überlagert wird. Die Kapazität Cₖ₃ ist wesentlich größer als die Kapazität Cₖ₂, die ihrerseits wesentlich größer als die Kapazität Cₖ₁ ist.

Die Phasenlage der Wechselspannung, die über den Transformator 12 eingekoppelt wird, kann mit geeigneten Mitteln auch direkt an das Teilentladungsmesssystem übermittelt und einer weiteren Auswertung zugeführt werden.

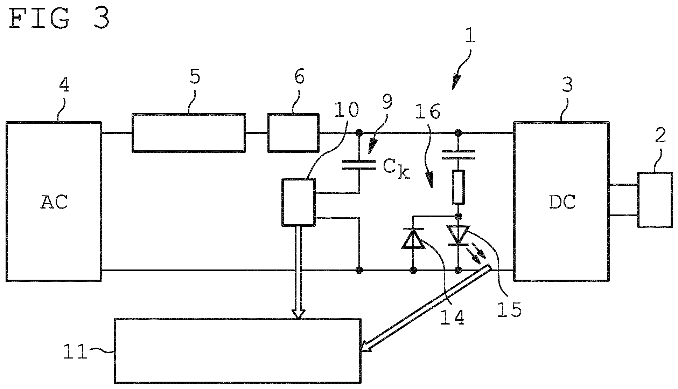

Fig. 3 zeigt eine schematische Darstellung einer wiederum abweichend ausgestalteten Messeinrichtung 1, bei der eine Freilaufdiode 14 und eine Leuchtdiode 15 in Abhängigkeit von der zeitlichen Veränderung des Messspannungsanteils in einem gesonderten Messzweig 16 aufleuchten. Die Lichtemission der Leuchtdiode 15 korreliert mit der zeitlichen Veränderung der verstärkten Restwelligkeit, die als periodisch oszillierende Messspannung der Gleichspannung überlagert wird. Durch eine Erfassung und Auswertung der optischen Signale der Leuchtdiode 15 kann der Phasenbezug der zeitgleich dazu gemessenen Teilentladungen ermittelt werden.

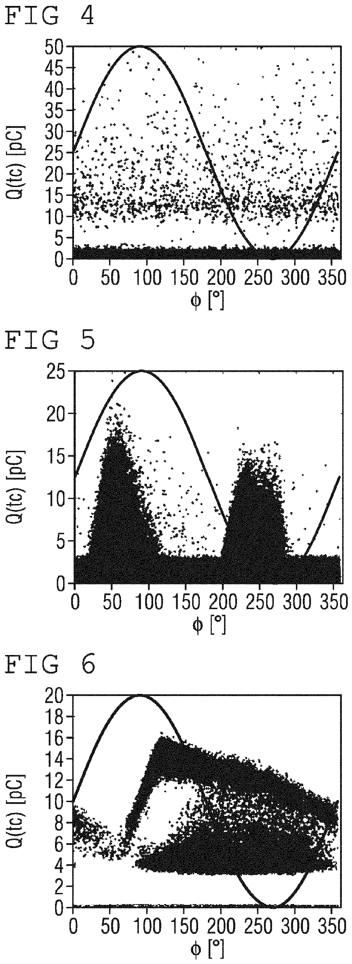

In den Fig. 4 bis 6 sind jeweils Messergebnisse einer großen Anzahl von Teilentladungen dargestellt. Die jeweils gemessenen Ladungsmengen der Teilentladungen sind in normierten Ladungseinheiten entlang der Y-Achse aufgetragen. Entlang der X-Achse ist der Phasenbezug über eine vollständige Schwingung von 360° aufgetragen. Derartige Darstellungen werden in der Praxis als Phasenlage/Häufigkeits-bezogene Matrix bzw. als PRPD-Pattern bezeichnet.

In Fig. 4 ist schematisch eine Anzahl von Messergebnissen des Teilentladungsmesssystems dargestellt, wobei die Teilentladungen mit einem nicht erfindungsgemäßen Verfahren ausschließlich durch eine Gleichspannung erzeugt wurden. Die einzelnen Teilentladungen sind im Wesentlichen gleichmäßig über die Schwingungsdauer der anregenden Wechselspannung verteilt, so dass kein charakteristischer Phasenbezug erkennbar ist.

In Fig. 5 ist schematisch eine Anzahl von Messergebnissen des Teilentladungsmesssystems dargestellt, wobei die Teilentladungen durch eine Messspannung mit einem Wechselspannungsanteil von 5 kV ausgelöst wurden, die einer Gleichspannung von 50 kV überlagert wurde. Die Teilentladungen wurden durch Lunker in einem Isolierungsmaterial der für die Messungen verwendeten Hochspannungskomponente verursacht. Deutlich erkennbar sind zwei Schwerpunkte der Häufigkeitsverteilung der Teilentladungen in Abhängigkeit von dem Phasenbezug der Teilentladungen bei einer Phasenlage von 50° und bei einer Phasenlage von 230°. Ausgehend von einer derart charakteristischen Häufigkeitsverteilung kann auf die Art der Fehlerursache, hier ein Lunker in dem Isolierungsmaterial, geschlossen werden.

In Fig. 6 ist schematisch eine Anzahl von Messergebnissen des Teilentladungsmesssystems dargestellt, wobei die Teilentladungen durch eine verstärkte Restwelligkeit der aus einer Wechselspannung erzeugten Gleichspannung angeregt wurden. Die Teilentladungen wurden durch eine äußere Korona-Entladung verursacht. Auch hier ist ein charakteristisches und von einer Gleichverteilung deutlich abweichendes Häufigkeitsmuster erkennbar, die sich von der in Fig. 5 gezeigten Häufigkeitsverteilung unterscheidet und ebenfalls Rückschlüsse auf die Art der Fehlerursache ermöglicht.

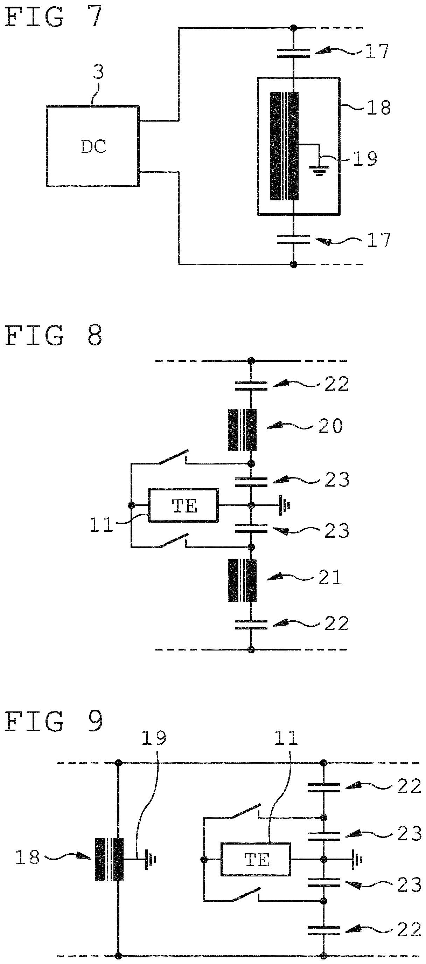

In den Fig. 7 bis 9 sind verschiedene Ausgestaltungen der Einkopplung einer Wechselspannung als sich mit der Zeit verändernde Messspannung sowie der Auskopplung der Teilentladungsmessung schematisch gezeigt. Die derartige Einkopplung einer Wechselspannung erfolgt zusätzlich zu der erfindungsgemäßen Nutzung der Restwelligkeit.

Bei dem in Fig. 7 gezeigten Ausführungsbeispiel wird die Wechselspannung mit Hilfe eines in Reihe geschalteten und über zwei Koppelkondensatoren 17 eingebundenen Transformators 18 mit einem geerdeten Mittenabgriff 19 erzeugt und der Gleichspannung der Gleichspannungseinrichtung 3 überlagert.

Bei dem in Fig. 8 gezeigten Ausführungsbeispiel wird die Wechselspannung durch zwei separate Transformatoren 20 und 21 über hochspannungsseitig angeordnete Koppelkondensatoren 22 der Gleichspannung überlagert, und über niederspannungsseitig angeordnete Koppelkondensatoren 23 eine Teilentladungsmessung ausgekoppelt.

Bei dem in Fig. 9 gezeigten Ausführungsbeispiel wird die Wechselspannung getrennt von der Auskopplung der Teilentladungsmessung eingekoppelt.

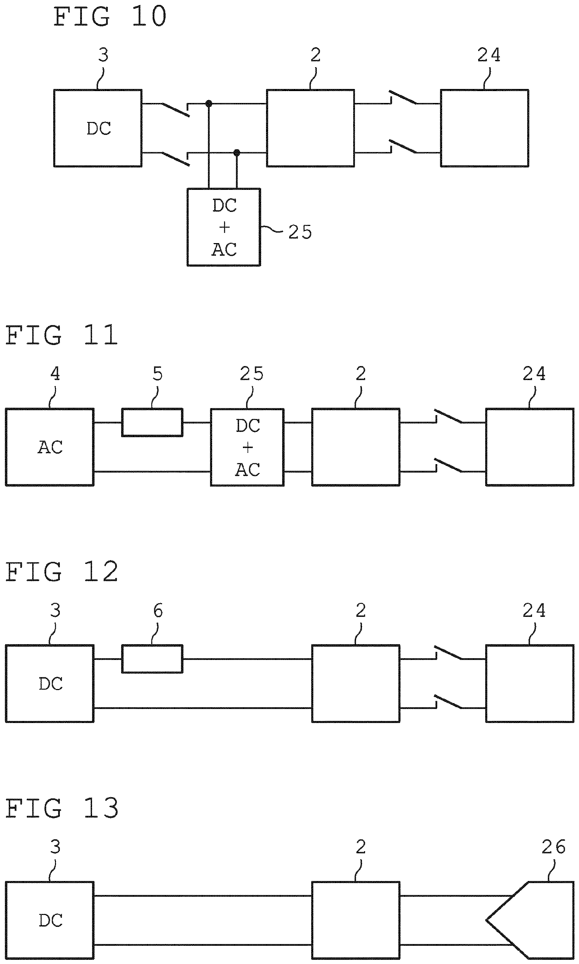

In den Fig. 10 bis 13 sind verschiedene Varianten der Einkopplung oder Erzeugung der Messspannung dargestellt, mit welcher jeweils die Hochspannungskomponente 2 beaufschlagt wird. Die Hochspannungskomponente 2 ist lediglich exemplarisch als Übertragungsstrecke und elektrisch leitende Verbindung zu einem elektrischen Verbraucher, bzw. einer Last 24 dargestellt. Die Last 24 kann in Abhängigkeit von den Eigenschaften der Last 24 entweder während der Durchführung einer Messung mit der Hochspannungskomponente 2 verbunden oder von dieser getrennt sein. Diese Ausführungsbeispiele entsprechen der Messung von Teilentladungen in einem Hochspannungskabel, das eine Last 24 mit einer Gleichspannungseinrichtung 3 verbindet.

In Fig. 10 kann die während einer üblichen Nutzung des Hochspannungskabels verwendete Gleichspannungseinrichtung 3 getrennt und durch eine Prüfspannungsquelle 25 ersetzt werden, die einen Gleichspannungsanteil und einen überlagerten Wechselspannungsanteil erzeugt. Der Gleichspannungsanteil der Prüfspannungsquelle 25 entspricht näherungsweise der Betriebsgleichspannung, die während des Betriebs von der Gleichspannungseinrichtung 3 erzeugt wird. Der Wechselspannungsanteil weist eine Amplitude von weniger als 50 % der Betriebsgleichspannung auf.

In Fig. 11 wird die der Gleichspannung überlagerte Messspannung, die der Prüfspannungsquelle 25 entspricht, durch eine modifizierte Gleichrichtung der Wechselspannung erzeugt, aus der mit der Gleichrichtereinrichtung 5 die Betriebsgleichspannung erzeugt wird.

In Fig. 12 wird die Messspannung durch eine Verstärkung der Restwelligkeit der gleichgerichteten Betriebsgleichspannung mit Hilfe der Verstärkereinrichtung 6 erzeugt und überlagert.

In Fig. 13 ist schematisch dargestellt, dass die Messspannung beispielsweise mit einem Marx-Generator 26 als Spannungsimpuls auf das Hochspannungskabel erzeugt wird und eine Wanderwelle verursacht, die als sich mit der Zeit verändernde Messspannung verwendet wird.

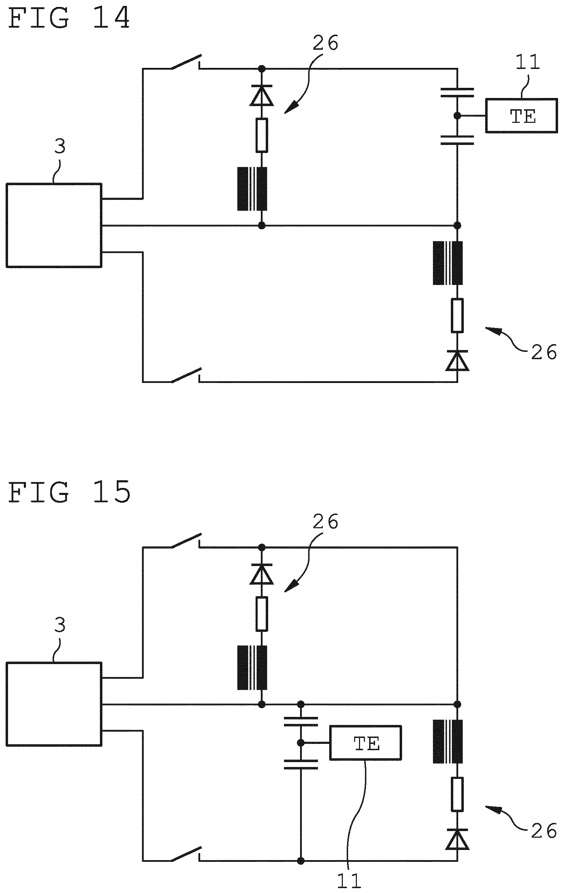

Die Fig. 14 und 15 zeigen jeweils eine schematische Darstellung von polaritätsabhängigen Messungen von Teilentladungen in der Hochspannungskomponente. Das Teilentladungsmesssystem 11 ist dabei jeweils parallel zu einem Messspannungszweig 26 mit einer polaritätsabhängig eingekoppelten Wechselspannung angeordnet.

## Patentansprüche

1. Verfahren zum Ermitteln von Kenngrößen eines Teilentladungsvorgangs in einer elektrischen Hochspannungskomponente (2), in welcher eine Teilentladung detektiert und gemessen wird, wobei an der Hochspannungskomponente (2) eine Gesamtspannung als Überlagerung von einer Betriebsgleichspannung und zusätzlich von einer sich mit der Zeit verändernden Messspannung angelegt wird, und wobei mehrfach eine durch die Teilentladung bewirkte Ladungsdifferenz und zeitgleich ein Phasenbezug zu der sich mit der Zeit verändernden Messspannung erfasst wird, um anschließend eine Fehlererkennung anhand der charakteristischen Eigenschaften des Phasenbezugs der mehrfach gemessenen Teilentladungen durchzuführen, **dadurch gekennzeichnet, dass** die Messspannung ausgehend von einer Restwelligkeit der aus einer Wechselspannung erzeugten Betriebsgleichspannung erzeugt wird, indem eine Restwelligkeit der Betriebsgleichspannung verstärkt wird, um eine Amplitude der verstärkten Restwelligkeit von mindestens 5 %, vorzugsweise von mehr als 10 % und besonders vorzugsweise von mehr als 20 % der Betriebsgleichspannung zu erhalten, und dass eine für einen vorgegebenen Fehlertyp charakteristische Abhängigkeit der Teilentladungen von der jeweiligen Phasenlage ermittelt und ausgewertet wird.

2. Verfahren nach Anspruch 1, **dadurch gekennzeichnet, dass** der Phasenbezug in einem gesonderten Messzweig relativ zu der Messspannung und getrennt von einem Messzweig für die Messung der Teilentladung erfasst wird.

3. Verfahren nach Anspruch 2, **dadurch gekennzeichnet, dass** die Teilentladung mit Hilfe eines ersten Koppelkondensators (7) ermittelt wird, dass der Phasenbezug mit Hilfe eines zweiten Koppelkondensators (9) ermittelt wird, wobei die Kapazität Cₖ₂ des zweiten Koppelkondensators (9) wesentlich größer als die Kapazität Cₖ₁ des ersten Koppelkondensators (7) ist.

4. Verfahren nach Anspruch 2, **dadurch gekennzeichnet, dass** die Ermittlung des Phasenbezugs mit Hilfe eines Lichtsignals einer von der Messspannung gespeisten Leuchtdiode (14, 15) getriggert wird.

5. Verfahren nach einem der Ansprüche 1 bis 4, **dadurch gekennzeichnet, dass** als Messspannung eine Wechselspannung verwendet wird, deren Scheitelwert weniger als 50 % der Betriebsgleichspannung, vorzugsweise weniger als 30 % und besonders vorzugsweise weniger als 15 % der Betriebsgleichspannung aufweist.

6. Verfahren nach einem der Ansprüche 1 bis 5, **dadurch gekennzeichnet, dass** die Hochspannungskomponente (2) wiederholt mit einer impulsförmigen Stoßspannung beaufschlagt wird.

7. Verfahren nach einem der Ansprüche 1 bis 6, **dadurch gekennzeichnet, dass** die Hochspannungskomponente (2) mit einer Wanderwelle beaufschlagt wird.

8. Verfahren nach einem der Ansprüche 1 bis 5, **dadurch gekennzeichnet, dass** jeweils nur die positive oder die negative Betriebsgleichspannungskomponente mit einer gleichgerichteten Wechselspannung beaufschlagt wird.

9. Verfahren nach einem der Ansprüche 1 bis 8, **dadurch gekennzeichnet, dass** über Schalteinrichtungen eine gezielte Messung von Teilentladungen der positiven oder der negativen Polarität über die Auskopplung mit Hilfe von niederspannungsseitigen Koppelkondensatoren erfolgt.

10. Verfahren nach einem der Ansprüche 1 bis 9, **dadurch gekennzeichnet, dass** eine Analyse der Messergebnisse mit Hilfe von statistischen Auswerteverfahren zu einer Erkennung von komplexen oder überlagerten Teilentladungen verwendet wird.

## Claims

1. A method for determining characteristics of a partial discharge event in an electric high-voltage component (2), in which a partial discharge is detected and measured, wherein a total voltage as a superposition of an operating DC voltage and additionally a time-variant measuring voltage is applied to the high-voltage component (2), and wherein a charge difference caused by the partial discharge and a phase relation to the time-variant measuring voltage is detected multiple times simultaneously, in order to subsequently carry out an error identification by means of the characteristic properties of the phase relation of the partial discharges measured multiple times, **characterized in that** the measuring voltage is generated based upon a ripple of an operating DC voltage generated from of an AC voltage, **in that** a ripple of the operating DC voltage is amplified to obtain an amplitude of the amplified ripple of at least 5 %, preferably more than 10 %, and particularly preferably more than 20 % of the operating DC voltage, and that a dependency of the partial discharges on the respective phase position, which is characteristic to a specified error type, is determined and evaluated.

2. The method according to claim 1, **characterized in that** the phase relation is detected in a separate measuring branch relative to the measuring voltage, and separately from a measuring branch for the measuring of the partial discharge.

3. The method according to claim 2, **characterized in that** the partial discharge is determined using a first coupling capacitor (7), that the phase relation is determined using a second coupling capacitor (9), wherein the capacitance Cₖ₂ of the second coupling capacitor (9) is significantly higher than the capacitance Cₖ₁ of the first coupling capacitor (7).

4. The method according to claim 2, **characterized in that** the determination of the phase relation is triggered using a light signal of a light-emitting diode (14, 15) powered by the measuring voltage.

5. The method according to one of claims 1 to 4, **characterized in that** an AC voltage is used as the measuring voltage, the peak value of which amounts to less than 50 % of the operating DC voltage, preferably less than 30% and particularly preferably less than 15 % of the operating DC voltage.

6. The method according to one of claims 1 to 5, **characterized in that** a pulse-type surge voltage is repeatedly applied to the high-voltage component (2).

7. The method according to one of claims 1 to 6, **characterized in that** a travelling wave is applied to the high-voltage component (2).

8. The method according to one of claims 1 to 5, **characterized in that** in each case only the positive or the negative operating DC voltage component is applied with a rectified AC voltage.

9. The method according to one of claims 1 to 8, **characterized in that** via switching means, a targeted measuring of partial discharges of the positive or negative polarity occurs via the decoupling using low-voltage-side coupling capacitors.

10. The method according to one of claims 1 to 9, **characterized in that** an analysis of the measuring results using statistical evaluation methods is used to detect complex or superimposed partial discharges.

## Revendications

1. Procédé de détermination de paramètres d'un procédé de décharge partielle dans un composant électrique haute tension (2) dans lequel une décharge partielle est détectée et mesurée, une tension totale étant appliquée sur le composant haute tension (2) sous forme de superposition d'une tension continue de fonctionnement et d'une tension de mesure variable dans le temps, et une différence de charge due à la décharge partielle et simultanément une référence de phase par rapport à la tension de mesure variable dans le temps étant détectées de manière répétée, pour ensuite réaliser une détection d'erreur au moyen des propriétés caractéristiques de la référence de phase des décharges partielles mesurées à plusieurs reprises,
**caractérisé en ce que** la tension de mesure est produite à partir d'une ondulation résiduelle de la tension continue de fonctionnement générée à partir d'une tension alternée, en renforçant une ondulation résiduelle de la tension continue de fonctionnement, pour obtenir une amplitude d'au moins 5 % de l'ondulation résiduelle renforcée, de préférence de plus de 10 % et idéalement de préférence de plus de 20 % de la tension continue de fonctionnement, et **en ce qu'**une dépendance des décharges partielles qui est caractéristique pour un type d'erreur prescrit de la phase respective est déterminée et évaluée.

2. Procédé selon la revendication 1, **caractérisé en ce que** la référence de phase est détectée dans une branche de mesure séparée relativement à la tension de mesure et distinctement d'une branche de mesure pour mesurer la décharge partielle.

3. Procédé selon la revendication 2, **caractérisé en ce que** la décharge partielle est déterminée à l'aide d'un premier condensateur de couplage (7) et **en ce que** la référence de phase est déterminée à l'aide d'un deuxième condensateur de couplage (9), la capacité Cₖ₂ du deuxième condensateur de couplage (9) étant considérablement supérieure à la capacité Cₖ₁ du premier condensateur de couplage (7).

4. Procédé selon la revendication 2, **caractérisé en ce que** la détermination de la référence de phase est déclenchée au moyen d'un signal lumineux d'une diode électroluminescente (14, 15) alimentée par la tension de mesure.

5. Procédé selon l'une quelconque des revendications 1 à 4, **caractérisé en ce qu'**on utilise comme tension de mesure une tension alternative dont la valeur de crête est inférieure à 50 % de la tension continue de fonctionnement, de préférence inférieure à 30 % et idéalement inférieure à 15 % de la tension continue de fonctionnement.

6. Procédé selon l'une quelconque des revendications 1 à 5, **caractérisé en ce que** le composant électrique haute tension (2) est appliqué, de manière répétée, avec une surtension transitoire sous forme d'impulsion.

7. Procédé selon l'une quelconque des revendications 1 à 6, **caractérisé en ce que** le composant électrique haute tension (2) est alimenté avec une onde progressive.

8. Procédé selon l'une quelconque des revendications 1 à 5, **caractérisé en ce que** seulement le composant respectivement positif ou négatif de la tension continue de fonctionnement est appliqué avec une tension alternative redressée.

9. Procédé selon l'une quelconque des revendications 1 à 8, **caractérisé en ce que** par le biais de dispositifs de commutation, une mesure ciblée de décharges partielles de la polarité positive ou négative est effectuée via le découplage à l'aide de condensateurs de couplage côté basse tension.

10. Procédé selon l'une quelconque des revendications 1 à 9, **caractérisé en ce qu'**une analyse des résultats des mesures est utilisée à l'aide de méthodes d'évaluation statistiques pour détecter des décharges partielles complexes ou superposées.
